# EUROPÄISCHE PATENTSCHRIFT

(11) **EP 3 311 637 B1**
(45) Veröffentlichungstag und Bekanntmachung des Hinweises auf die Patenterteilung: **13.04.2022**
(21) Anmeldenummer: 16731064.8
(22) Anmeldetag: 10.06.2016
(51) Int. Cl.: H05K 5/02, H05K 5/00, H02B 1/06, G01R 11/24, H02G 3/14

(54) **GEHÄUSE FÜR EIN GERÄT**
HOUSING FOR A DEVICE
DISPOSITIF DE LOGEMENT D'UN APPAREIL

(30) Priorität: 16.06.2015 CH 8662015
(43) Veröffentlichungstag der Anmeldung: 25.04.2018
(73) Patentinhaber: Landis+Gyr AG, 6330 Cham (CH)
(72) Erfinder: ZIBUNG, Werner, 6418 Rothenthurm (CH)
(74) Vertreter: IPrime Rentsch Kaelin AG
(86) Internationale Anmeldenummer: PCT/EP2016/063287
(87) Internationale Veröffentlichungsnummer: WO 2016/202692

(56) Entgegenhaltungen:
- WO-A2-2014/170333
- DE-A1-102013 224 904
- US-A- 4 149 741
- US-A1- 2010 296 259
- US-A1- 2012 027 511

## Beschreibung

### TECHNISCHES GEBIET

Die Erfindung bezieht sich auf ein Gehäuse für ein Gerät, wobei das Gehäuse mindestens ein erstes Gehäuseteil und ein zweites Gehäuseteil umfasst, die jeweils mindestens eine Halterungseinrichtung aufweisen für die Halterung eines Verschlusselements, das sich in einem verschlossen Zustand des Gehäuses zumindest abschnittsweise entlang der jeweiligen mindestens einen Halterungseinrichtung beider Gehäuseteile erstreckt und diese sichernd verbindet, wobei zwischen dem Verschlusselement und einer Wandung der jeweiligen Halterungseinrichtung beider Gehäuseteile ein formschlüssiger Eingriff besteht, und das Verschlusselement zumindest abschnittsweise in die Wandung eindringt.

### STAND DER TECHNIK

Aus dem Stand der Technik sind Gehäuse für Geräte bekannt. Gehäuse für Geräte wie Stromzähler, Wasserzähler, Gaszähler, etc. werden oft mit einer Plombierung versehen, um den nicht autorisierten Zugang zum Gerät zu verhindern. Die Plombierung kann eine Schnur und ein Siegel umfassen, wobei die Schnur durch eine Durchführung in einem Schraubenkopf und durch eine am Gerät angeformte Lasche geführt ist. Zum Öffnen des Gehäuses ist das Entfernen der Schraube und das Durch-trennen der Schnur erforderlich. Werkzeuge zum Herstellen des Siegels sind nur autorisierten Fachkräften zugänglich. Das unautorisierte Öffnen des Gehäuses wird dadurch verhindert.

Das Dokument US 4,149,741 zeigt beispielsweise einen Stromzähler. Ein Strommessgerät wird an einem Sockel mit einem Versiegelungsband befestigt, wobei das unautorisierte Öffnen am Versiegelungsband feststellbar ist.

US 2010/296259 A1 zufolge umfasst ein elektronisches Gerät ein Gehäuse, das eine Vielzahl von elektronischen Elementen darin aufnimmt, und ein Klammerelement, um zu bestimmen, ob das Gehäuse getrennt wurde. Das Gehäuse umfasst eine Abdeckung, eine Basis und ein Halteelement mit einem Paar von Aufnahmeabschnitten. Einer der Aufnahmeabschnitte steht von einer inneren Oberfläche der Abdeckung vor, während der andere Aufnahmeabschnitt von einer inneren Oberfläche der Basis vorragt, die dem einen Aufnahmeabschnitt entspricht. Das Klammerelement ist in dem Paar von Aufnahmeabschnitten aufgenommen, wenn die Abdeckung auf der Basis montiert ist.

US 2012/027511 A1 betrifft eine Befestigungsvorrichtung, die einen ersten und zweiten Haken, ein Anschlagelement und zwei feste Platten umfasst. Der erste Haken ist an einem ersten Artikel angeordnet und weist einen ersten Hakenabschnitt auf. Das Anschlagelement ist an einem ersten Gegenstand angeordnet und ist vom ersten Haken beabstandet. Die festen Platten sind auf dem zweiten Gegenstand angeordnet und sind voneinander beabstandet. Jede feste Platte hat eine Schwenknut und einen ersten Positionierungsabschnitt. Der zweite Haken ist schwenkbar zwischen den festen Platten verbunden und erstreckt sich zwischen dem ersten Hakenabschnitt und dem Anschlagelement. Der zweite Haken hat einen zweiten Hakenabschnitt, der lösbar mit dem ersten Hakenabschnitt, zwei Schwenkwellen und zwei zweiten Positionierungsabschnitten in Eingriff steht. Die Schwenkwellen sind jeweils innerhalb der Schwenknuten drehbar. Jeder zweite Positionierungsabschnitt greift in den entsprechenden ersten Positionierungsabschnitt ein.

WO 2014/170333 A2 betrifft ein elektronisches Gerät mit einer Leiterplatte, wobei die Leiterplatte von einem Gehäuse mit zwei über eine Schraube verbundenen Gehäuseteilen umschlossen ist.

### DARSTELLUNG DER ERFINDUNG

Eine Aufgabe der Erfindung besteht darin, zumindest gewisse Nachteile des Standes der Technik zu vermeiden. Eine weitere Aufgabe der Erfindung besteht darin ein Gehäuse für ein Gerät anzugeben, wobei das Gehäuse aus einem ersten Gehäuseteil und einem zweiten Gehäuseteil zusammengefügt ist, und wobei das unautorisierte Öffnen des Gehäuses verhindert ist.

Diese und andere Aufgaben werden durch die Merkmale des Anspruchs 1 gelöst. Ausführungsformen der Erfindung ergeben sich aus den abhängigen Ansprüchen.

Das erfindungsgemässe Gehäuse für ein Gerät umfasst ein erstes Gehäuseteil und ein zweites Gehäuseteil, die in einem verschlossenen Zustand des Gehäuses zusammengefügt sind. Je nach konkretem Einsatzgebiet umfasst die Gehäuseverbindung einen einfachen Passitz oder auch bevorzugt eine qualifizierte Verbindung (bspw. Dichtigkeit bezüglich Wasser oder Gaseintritt) oder einen sichernden Sitz, wie beispielsweise eine Verriegelung oder einen Klemmsitz, welche die Gehäuseteile sichernd verbindet. Das Gerät umfasst eine elektronische Schaltung, eine elektrotechnische Anwendung, etc., insbesondere aus dem Bereich des Energiemanagements, wobei vom Gerät Abnahmemengen eines Verbrauchers zur Abrechnung registriert werden und das Gerät vor Manipulationen geschützt im Gehäuse aufgenommen sein soll, um eine mögliche Verfälschung der Abrechnungswerte durch den Verbraucher zu verhindern.

Die Gehäuseteile weisen jeweils mindestens eine Halterungseinrichtung auf für die Halterung eines Verschlusselements, das sich im verschlossenen Zustand zumindest abschnittsweise entlang der jeweiligen mindestens einen Halterungseinrichtung beider Gehäuseteile erstreckt. Die Halterungseinrichtungen und das Verschlusselement sind derart ausgebildet, dass das Verschlusselement und eine Wandung der jeweiligen Halterungseinrichtung beider Gehäuseteile formschlüssig zusammenwirken, wobei das Verschlusselement zumindest abschnittsweise in die Wandung eindringt.

Die erfindungsgemässe Lösung hat den Vorteil, dass das erfindungsgemässe Verschlusselement eine Doppelfunktion als Verriegelungsteil und zur Versiegelung bzw. Plombierung ausübt. Somit lässt sich das Gehäuse in einem Arbeitsschritt im verschlossenen Zustand verriegeln und versiegeln bzw. plombieren. Das Verschlusselement ist dabei bevorzugt so ausgelegt, dass das die beiden Gehäuseteile nicht wieder voneinander trennbar sind, ohne das Verschlusselement zu zerstören oder zumindest derart zu beschädigen oder verformen, dass der Öffnungsvorgang nachweisbar ist. Die erwähnte Gehäuseverbindung, also beispielsweise der Passsitz oder bevorzugt die qualifizierte Verbindung, wirkt bevorzugt mit dem Verschlusselement zusammen, um die sichernde oder dichtende Verbindung zu optimieren.

Mit anderen Worten ist das Verschlusselement bevorzugt als eine Art Einwegbauteil ausgelegt, das nicht wiederholt verwendbar ist, um sicherzustellen, dass zum Öffnen des Gehäuses ein Brechen der Versiegelung bzw. Plombierung unumgänglich ist. Sobald auf die Gehäuseteile wirkende Öffnungskräfte eine Biegestreckgrenze des Verschlusselementes übersteigen, reisst dieses zumindest abschnittsweise.

Beispielsweise können am Verschlusselement vorspringende Abschnitte wie Ecken, Kanten oder ähnliches ausgeformt sein, die zumindest abschnittsweise in die Wandung eindringen können, um einen Formschluss zu bewirken, wobei sich besagte Abschnitte und Halterungseinrichtung in einer Projektion entlang einer Richtung überlagern, in der die Gehäuseteile zusammenzusetzen sind bzw. entgegen der sie aus dem verschlossenen Zustand zum Öffnen des Gehäuses voneinander zu trennen währen. Um ein Eindringen oder Eingreifen zu ermöglichen, ist das Verschlusselement bevorzugt aus einem härteren Material als die Wandung ausgeformt sein. Somit verdrängt das Verschlusselement beim Verschliessen das Wandungsmaterial. Beispielsweise ist das Verschlusselement aus Metall und die Wandung aus einem Kunststoff hergestellt.

In einer Ausführungsform besteht zwischen dem Verschlusselement und der Halterungseinrichtung ein kraftschlüssiger Eingriff. Zusätzlich zum Formschluss ergibt wird dadurch das Verschlusselement in der Halterungseinrichtung festgehalten.

In einer Ausführungsform können die Halterungseinrichtungen und das Verschlusselement derart ausgebildet sein, dass beim Zusammenfügen des ersten Gehäuseteils und des zweiten Gehäuseteils das Verschlusselement in die Halterungseinrichtungen hineingesteckt werden kann. Da das Verschlusselement in die Halterungseinrichtungen hinein gesteckt werden kann, lässt sich das Gehäuse einfach zusammenfügen. Das Verschlusselement kann beispielsweise einseitig in eines der Gehäuseteile einsteckbar ausgestaltet sein. Nach dem einseitigen Einstecken des Verschlusselementes können die Gehäuseteile zusammenfügt werden.

In einer Ausführungsform kann sich das Verschlusselement nach dem Zusammenfügen des ersten Gehäuseteils und des zweiten Gehäuseteils mit den Halterungseinrichtungen verhaken. Das Verhaken kann beispielsweise durch ein Eindringen besagter Kanten oder Ecken des Verschlusselementes in die Wandung bzw. den Formschluss zwischen Verschlusselement und Halterungseinrichtung bewirkt werden. Die Ecken und Kanten können Teile von Formschlussabschnitten des Verschlusselementes sein, die komplementär zu Gegenformschlussabschnitten der Halterungseinrichtungen ausgeformt sein oder derart ausgestaltet sein können, dass die Formschlussabschnitte durch ein zumindest abschnittsweises Eindringen in die Wandung der Halterungseinrichtungen darin Gegenfomschlussabschnitte ausbilden, wobei das Material der Wandung verdrängt wird und sich Vertiefungen bzw. Einkerbungen in der Wandung ausbilden, in denen sich das Verschlusselement verhakt.

Indem sich das Verschlusselement mit den Halterungseinrichtungen verhakt, können die Gehäuseteile permanent zusammengefügt sein. Durch das permanente Zusammenfügen sind die Gehäuseteile über die gesamte Lebensdauer des Gehäuses miteinander verbunden. Ein Trennen der Gehäuseteile ist nicht erwünscht. Zum Trennen der Gehäuseteile muss die Verhakung aufgebrochen werden, wodurch ein nicht autorisiertes Öffnen des Gehäuses verhindert oder zumindest angezeigt wird. Es kann vorgesehen sein, dass statt der Verhakung deren Verankerung aufgebrochen werden muss.

In einer Ausführungsform ist das Verschlusselement plättchenförmig ausgebildet. Der Platzbedarf des Verschlusselements ist somit klein und dieses kann deshalb in unterschiedlichsten Gehäuseteilen angeordnet werden. Das Verschlusselement lässt sich kostengünstig in wenigen Arbeitsschritten herstellen, beispielsweise in einem Stanzverfahren oder Spritzgussverfahren. Um das Verschlusselement plättchenförmig auszubilden kann dieses beispielsweise aus einem Blechstreifen gestanzt sein. Alternativ kann das Verschlusselement aus einem Spezialkunststoff gefertigt sein oder es kann auch ein Blechelement integriert sein (z.B. Inmold-Verbindung).

In einer Ausführungsform sind am Verschlusselement federnde Elemente ausgebildet, die sich mit den Halterungseinrichtungen verhaken können. Die federnden Elemente können so ausgestaltet sein, dass sie ein ungehindertes Einstecken des Verschlusselements in einer Einführrichtung in die Halterungsvorrichtung ermöglichen. Wenn Kräfte entgegen der Einführrichtung auf das in der Halterungsvorrichtung aufgenommene Verschlusselement einwirken, bewirken die federnden Elemente, dass das Verschlusselement in die Wandung eingreift oder -dringt, wodurch das Verhaken mit den Halterungsvorrichtungen sichergestellt ist. An den federnden Elementen können die Ecken oder Kanten des Verschlusselementes zum Herstellen des Formschlusses mit der Halterungseinrichtung gehalten oder ausgeformt sein. Die federnden Elemente, Ecken und/oder Kanten können die Forschlussabschnitte ausbilden.

Mit anderen Worten können die Verschlusselemente so ausgestaltet sein, dass sie nur in Einführrichtung in die Halterungen einführbar sind. Die Federelemente können sich wie Widerhaken quer zur Einführrichtung aufstellen und in die Wandung der Halterungsvorrichtung eingraben, sobald Kräfte entgegen der Einführrichtung auf das Verschlusselement einwirken. Ein Herausziehen des Verschlusselementes aus der Halterungseinrichtung wäre somit verhindert.

In einer Ausführungsform weist das Verschlusselement zwei gegenüberliegende Seitenflächen auf, wobei die am Verschlusselement ausgebildeten federnden Elemente von einer der Seitenflächen abstehen. Alternativ stehen die federnden Elemente abwechselnd von den gegenüberliegenden Seitenflächen ab. Je nach Ausgestaltung ist das Verschlusselement vorgesehen, sich mit einer oder mehreren Wandungen der Halterungseinrichtung zu Verhaken. Auch ist denkbar, das Verschlusselement mit Hilfe der federnden Elemente und/oder zusätzlichen Codierungselementen in einer Projektion entlang der Einführrichtung derart komplementär zur Halterungseinrichtung auszugestalten, dass eine Codierung der Verschlusselemente bzw. deren gewünschte Ausrichtung zum Einführen in die Halterungseinrichtung vorgegeben ist. Somit können Fehlbestückungen der Gehäuseteile mit Verschlusselementen vermieden bzw. eindeutige Paarungen verschiedener Gehäuseteile mit jeweiligen Verschlusselementen vorgegeben werden.

In einer Ausführungsform sind die Halterungseinrichtungen quaderförmig ausgebildet. Beispielsweise ist das Verschlusselement spiegelsymmetrisch zu wenigstens einer Mittelebene des Verschlusselementes ausgestaltet. Die wenigstens eine Mittelebene kann im Wesentlichen rechtwinklig zur Einführrichtung verlaufen. Somit wäre das Verschlusselement mit seinen beiden Seiten gleichermassen in die Halterungseinrichtung einführbar und Fehlsteckungen können vermieden werden.

In einer Ausführungsform weisen die Halterungseinrichtungen mindestens eine Rippe derart auf, dass sich das Verschlusselement mit der mindestens einen Rippe verhaken kann. Die Rippe weist eine stark gekrümmte Oberfläche auf, welche ein Verhaken bzw. plastisch und/oder elastisches Verformen der Wandung der Halterungseinrichtung durch das Verschlusselement begünstigt. Die Rippe verläuft bevorzugt im Wesentlichen parallel zur Einführrichtung. Die Rippe begünstigt das Verhaken. Statt einer Rippe kann eine Fläche einer beliebiger Form vorgesehen sein, welche das Verhaken ermöglicht oder begünstigt.

In einer Ausführungsform weisen die Halterungseinrichtungen einander gegenüberliegende Paare von parallel zueinander verlaufenden Rippen auf. Beim Einstecken des Verschlusselements wird dieses optimal geführt, wobei das Verhaken begünstigt ist. Statt Paaren von parallel zueinander verlaufenden Rippen können Flächen beliebiger Form vorgesehen sein, um das Verhaken des Verschlusselements zu ermöglichen oder zu begünstigen.

In einer Ausführungsform sind das Verschlusselement und die Halterungseinrichtungen derartig ausgebildet, dass das Verschlusselement in den Halterungseinrichtungen zentriert werden kann. Dies wird beispielsweise mit quaderförmigen Halterungseinrichtungen mit Paaren von parallel verlaufenden Rippen erreicht. Das Zentrieren vereinfacht das Einstecken des Verschlusselements. Durch das Zentrieren wird das Verschlusselement beim Einstecken seitlich derart geführt, dass es nach dem Einstecken in der Halterungseinrichtung eine vorgesehene Position einnimmt. Beim Zentrieren werden Seitenflächen, federnde Elemente, Kanten, etc. des Verschlusselements auf Rippen, Flächen, etc. der Halterungseinrichtungen abgestützt.

In einer Ausführungsform sind das Verschlusselement und die Halterungseinrichtungen ausgebildet sind, dass sich das Verschlusselement in zwei unterschiedlichen Positionen in den Halterungseinrichtungen erstrecken kann. Dadurch wird die Flexibilität beim Anbringen des Verschlusselements erhöht.

In einer Ausführungsform kann sich das Verschlusselement im Wesentlichen vollständig innerhalb der Halterungseinrichtungen erstrecken. Der für die Verriegelung zur Verfügung stehende Raum wird dadurch optimal ausgenutzt. Das Verschlusselement kann von ausserhalb des Gehäuses im verschlossenen Zustand unzugänglich in den Halteeinrichtungen aufgenommen sein, was hilft, eine Manipulation des Verschlusselementes zu verhindern.

In einer Ausführungsform weist das Verschlusselement ein Sicherheitselement auf. Das Sicherheitselement ist "passiv" oder "aktiv" ausgestaltet. Ein "passiv" ausgestaltetes Sicherheitselement ist beispielsweise für das Ab- oder Auslesen von Informationen ausgestaltet. Ein "aktiv" ausgestaltetes Sicherheitselement ist beispielsweise für das Abspeichern oder Erfassen von Daten ausgestaltet. Das Sicherheitselement umfasst beispielsweise eine Prägung, welche mit einem Spezialwerkzeug herzustellen ist, das nur autorisierten Personen zur Verfügung steht. Das Sicherheitselement umfasst beispielsweise einen elektronischen Datenträger, der elektronische Daten aufweist, welche mit einem elektronischen Schlüssel herstellbar sind, der nur autorisierten Personen zur Verfügung steht. Der elektronische Datenträger ist beispielsweise als RFID-Tag (RFID: Radio Frequence Identification) ausgeführt. Am Gehäuse lässt sich von aussen ohne mechanischen Eingriff mit einem RFID-Lesegerät überprüfen, ob das Verschlusselement mit dem Sicherheitselement korrekt eingesetzt ist oder ob ein nicht autorisiertes Öffnen des Gehäuses stattgefunden hat.

In einer Ausführungsform sind mehrere Verschlusselemente und eine entsprechende Anzahl Halterungseinrichtungen vorgesehen. Das spielfreie Zusammenfügen der Gehäuseteile lässt sich dadurch verbessern.

In einer Ausführungsform sind eines oder mehrere Verbindungselemente vorgesehen, um die Gehäuseteile miteinander zu verbinden. Die Verbindungselemente können ausgelegt sein, um die Gehäuseteile sehr stabil zu verbinden. Die Verbindungselemente sind entfernbar und basieren beispielsweise auf einer Schraubverbindung, einer Schnappverbindung, etc. Die Verbindungselemente können ausgestaltet sein, um die Gehäuseteile entgegen hoher Kräfte miteinander zu verbinden. Insbesondere können die Verbindungselemente ausgestaltet sein, um die Gehäuseteile entgegen höherer Kräfte miteinander zu verbinden, als dies durch die Verschlusselemente ermöglicht ist.

### KURZE BESCHREIBUNG DER ZEICHNUNGEN

Folgenden ist die Erfindung beispielhaft anhand möglicher Ausführungsformen mit Bezug auf die beigefügten Zeichnungen genauer beschrieben. Die bei diesen Ausführungsformen dargestellten Merkmalskombinationen dienen lediglich Anschauungszwecken. Einzelne Merkmale können nach Maßgabe ihrer oben beschriebenen Vorteile auch weggelassen werden, wenn es bei bestimmten Anwendungen auf den Vorteil des jeweiligen Merkmals nicht ankommt. In der Beschreibung der Ausführungsformen sind der Einfachheit halber gleiche Merkmale und Elemente mit gleichen Bezugszeichen versehen.

Es zeigen:
- Fig. 1: schematisch ein Gehäuse mit daran angebrachten Verschlusselementen und Verbindungselementen;
- Fig. 2: schematisch eine Detailansicht einer im Bereich einer Ecke des Gehäuses angebrachten Halterungseinrichtung;
- Fig. 3: schematisch eine Variante eines Verschlusselements, welches für die Halterung in Halterungseinrichtungen der Gehäuseteile vorgesehen ist;
- Fig. 3a: schematisch eine Strichzeichnung einer Variante eines Verschlusselements, welches für die Halterung in Halterungseinrichtungen der Gehäuseteile vorgesehen ist;
- Fig. 3b: schematisch eine Strichzeichnung einer Variante eines Verschlusselements, welches für die Halterung in Halterungseinrichtungen der Gehäuseteile vorgesehen ist;
- Fig. 4: schematisch ein Verschlusselement, welches in einer Halterungseinrichtung eingesteckt ist;
- Fig. 4a: schematisch eine Strichzeichnung eines Verschlusselements, welches in einer Halterungseinrichtung eingesteckt ist;
- Fig. 5: schematisch eine Momentaufnahme beim Zusammenfügen von Gehäuseteilen zu einem Gehäuse;
- Fig. 6: schematisch ein Schnittbild eines Gehäuses mit einem ersten Gehäuseteil und einem zweiten Gehäuseteil;
- Fig. 7: schematisch einen Querschnitt durch ein Gehäuse, welches aus einem ersten Gehäuseteil und einem zweiten Gehäuseteil zusammengefügt ist; und
- Fig. 8: schematisch in einem Schnittbild eine Detailansicht eines Gehäuses mit einem Verschlusselement.

### WEG(E) ZUR AUSFÜHRUNG DER ERFINDUNG

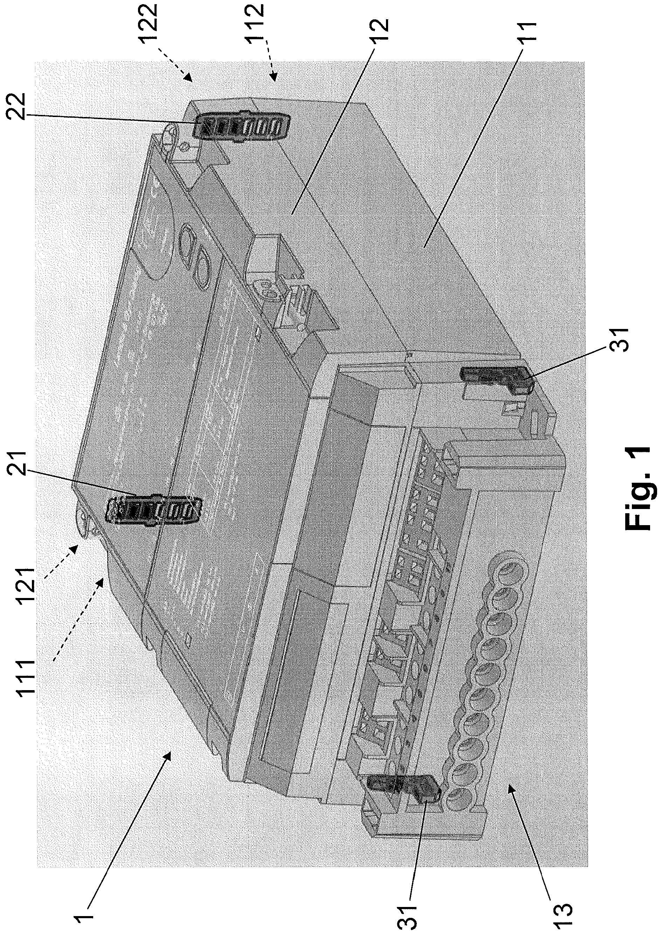

Figur 1 zeigt schematisch ein Gehäuse 1. Das Gehäuse weist einen ersten Gehäuseteil 11 und einen zweiten Gehäuseteil 12 auf, die zusammengefügt sind. Das Gehäuse 1 ist für ein Gerät vorgesehen, welches in der Figur 1 nicht ersichtlich ist. Hingegen sind in der Figur 1 Anschlusseinrichtungen 13 ersichtlich, welche dazu dienen, eine Wirkverbindung zum im Gehäuse 1 angeordneten Gerät herzustellen. Das Gerät ist ein elektrisches oder elektronisches Gerät, beispielsweise ein Stromzähler, ein Wärmezähler, ein Kältezähler, ein Wasserzähler, ein Steuergerät, etc. Die Wirkverbindung ist beispielsweise eine elektrische Verbindung, eine Fluidverbindung, etc.

Das Gehäuse 1 weist Verschlusselemente 21, 22 auf. Wie in Figur 1 schematisch dargestellt, sind die Verschlusselemente 21, 22 im Bereich von Ecken des Gehäuses 1 angebracht. Die Verschlusselemente 21, 22 sind an anderen Stellen des Gehäuses 1 angebracht, beispielsweise in der Mitte von Kanten des Gehäuses 1, etc.

Das Gehäuse 1 weist Verbindungselemente 31, 32 auf, um die Gehäuseteile 11, 12 miteinander zu verbinden. Wie in Figur 1 schematisch dargestellt, sind die Verbindungselement 31, 32 im Bereich von Ecken des Gehäuses 1 angebracht. Die Verbindungselemente 31, 32 sind an anderen Stellen des Gehäuses 1 angebracht, beispielsweise in der Mitte von Kanten des Gehäuses 1, in einer Umgebung von Verschlusselementen 21, 22, etc.

Das Gehäuse 1 kann eine grössere Anzahl Verschlusselemente 21, 22 aufweisen, um die Gehäuseteile 11, 12 zu verriegeln, bevorzugt aber mindestens vier solcher Verschlusselemente. In einer Variante ist ein einzelnes Verschlusselement 21 vorgesehen. Die Funktion des Verriegelns bedeutet, dass ein Auseinandernehmen der Gehäuseteile 11, 12 ohne Hinweis auf eine Manipulation verhindert ist. Ferner bewirkt das Verriegeln ein spielfreies Zusammenhalten der Gehäuseteile 11, 12. Zusätzlich oder alternativ können weitere Gehäuseverbindungen für ein spielfreies Zusammenhalten der Gehäuseteile sorgen. Die Verriegelung kann aufgebrochen werden, falls die Kraft zum Auseinandernehmen der Gehäuseteile 11, 12 stark erhöht wird. Beim Aufbrechen der Verriegelung entstehen sichtbare Spuren, die das Aufbrechen der Verriegelung anzeigen. Die Spuren des Aufbrechens können an den Gehäuseteilen 11, 12 respektive an den weiter unten beschriebenen Halterungseinrichtungen, an den Verschlusselementen 21, 22, etc. sichtbar sein. Bevorzugt sind die Spuren des Aufbrechens an den Verschlusselementen 21, 22 sichtbar, beispielsweise können Brechspuren, abgebrochene Elemente, etc. das Aufbrechen anzeigen. Dazu können Sollbruchstellen an den Verschlusselementen 21, 22 vorgegeben sein. Die Verriegelung stellt eine "Sealing-for-Life" Funktion zur Verfügung, d.h. das Gehäuse ist für die gesamte Lebensdauer des Geräts abgedichtet.

Das Gehäuse 1 kann eine beliebige Anzahl Verbindungselemente 31, 32 aufweisen, um die Gehäuseteile miteinander zu verbinden. In einer Varianten sind keine Verbindungselemente 31, 32, sondern nur Verschlusselemente 21, 22 vorgesehen. Die Funktion des Verbindens bedeutet, dass die Gehäuseteile 11, 12 auch bei hohen Trennkräften miteinander verbunden bleiben. Die Verbindungselemente 31, 32 können in der Form von Schnappeinrichtungen, Schraubeinrichtungen, etc. ausgeführt sein. Wie in Figur 1 schematisch dargestellt, ist an zwei Ecken des Gehäuses je ein Verbindungselement 31, 32 vorgesehen, welche in der Form einer Schnappeinrichtung ausgeführt sind.

Das Gehäuse 1 kann aus Kunststoff hergestellt sein. Das Gehäuse 1 kann durchsichtige Teile aufweisen, beispielsweise um einen Zählerstand eines im Gehäuse 1 angeordneten Zählers ablesen zu können, um Funktionen eines im Gehäuse 1 angeordneten Geräts überprüfen zu können, etc.

Die in Figur 1 dargestellten Verschlusselemente 21, 22 erstrecken sich in dafür vorgesehenen Halterungseinrichtungen 111, 121, 121, 122 welche an den Gehäuseteilen 11, 12 vorgesehen sind. Für das Verschlusselement mit dem Bezugszeichen 21 sind Halterungseinrichtungen mit den Bezugszeichen 111, 112 vorgesehen. Für das Verschlusselement mit dem Bezugszeichen 22 sind Halterungseinrichtungen mit den Bezugszeichen 121, 122 vorgesehen. Die Halterungseinrichtungen 111, 121, 121, 122 und die Verschlusselemente 21, 22 sind derart ausgebildet, dass beim Zusammenfügen des ersten Gehäuseteils und des zweiten Gehäuseteils das Verschlusselement in die Halterungseinrichtungen 111, 121, 121, 122 hineingesteckt werden kann, wobei sich das Verschlusselement nach dem Zusammenfügen des ersten Gehäuseteils und des zweiten Gehäuseteils mit den Halterungseinrichtungen verhaken kann, um eine Verriegelung herzustellen. Die Halterungseinrichtungen 111, 121, 121, 122 sind in der Figur 1 nicht ersichtlich, jedoch mit gestrichelten Pfeilen angedeutet.

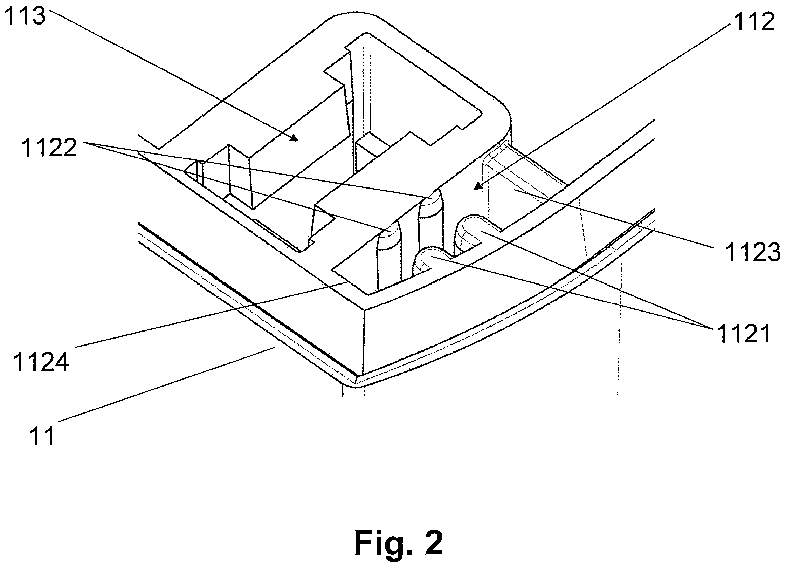

Figur 2 zeigt schematisch eine Detailansicht einer Ecke eines Gehäuseteils 11, welches dem Gehäuseteil mit Bezugszeichen 11 der Figur 1 entspricht. Im Bereich der Ecke des Gehäuseteils 11 ist eine Halterungseinrichtung 112 sichtbar, welche am Gehäuseteil 11 angebracht ist. Die Halterungseinrichtung 112 ist vorgesehen, um das in Figur 1 gezeigte Verschlusselement mit dem Bezugszeichen 22 im Gehäuseteil mit dem Bezugszeichen 11 einzustecken. Die Halterungseinrichtung 112 kann schacht- und/oder schlitzförmig ausgeführt sein und einen quaderförmigen Innenraum aufweisen. Wie in Figur 2 schematisch dargestellt, ist eine der vier Flächen des quaderförmigen Innenraums gewölbt ausgeführt, wobei die Wölbung einer äusseren Form des Gehäuseteils 11 angepasst ist. Die gewölbte Fläche und die dazu gegenüberliegende Fläche des quaderförmigen Innenraums weisen gegenüberliegende Paare von im Wesentlichen parallel zueinander verlaufenden Rippen 1121, 1122 auf. Die anderen zwei einander gegenüberliegenden Flächen des quaderförmigen Innenraums bilden Führungsflächen 1123, 1124. Der Abstand zwischen den Paaren von parallel verlaufenden Rippen 1121, 1122 und der Abstand zwischen den Führungsflächen 1123, 1124 sind angepasst für die Halterung eines Verschlusselements 21, 22. Das Paar Rippen mit dem Bezugszeichen 1121 ist an der gewölbten Fläche des quaderförmigen Innenraums angeordnet. Die Rippen weisen entsprechend der Wölbung unterschiedliche Dimensionen auf, damit der Abstand zwischen den Paaren von parallel verlaufenden Rippen 1121, 1122 einen gewünschten Wert aufweist. Der Abstand zwischen den parallel verlaufenden Rippen 1121, 1122 ist im Wesentlichen über die gesamte Länge der parallel verlaufenden Rippen 1121, 1122 gleich gross.

In entsprechender Weise ist am Gehäuseteil 12, welches in der Figur 2 nicht gezeigt ist, eine Halterungseinrichtung 122 vorgesehen, welche mit der am Gehäuseteil 11 angebrachten Halterungseinrichtung 112 fluchtet. Die Halterungseinrichtungen 112, 122 sind ausgebildet, um ein Verschlusselement 22 aufzunehmen, welches sich in den Halterungseinrichtungen 112, 122 erstrecken kann.

Wie in Figur 2 schematisch dargestellt, ist in einer Umgebung der Halterungseinrichtung 112 des Gehäuseteils 11 ein Verbindungslager 113 für ein Verbindungselement 33 (in Figur 2 nicht ersichtlich) gezeigt. Das Verbindungslager 113 ist am Gehäuseteil 11 angeformt und weist geeignete Merkmale wie z.B. eine Durchführung, einen Sitz, etc. auf, um ein Lager für ein Verbindungselement 33 zur Verfügung zu stellen. Das Verbindungslager 113 des Gehäuseteils mit dem Bezugszeichen 11 fluchtet mit einem entsprechend Verbindungslager 123 eines weiteren Gehäuseteils 12 (in Figur 2 nicht dargestellt), wobei die Verbindungslager 113, 123 und das Verbindungselement 33 eingerichtet sind, eine Verbindung zwischen den Gehäuseteilen 11, 12 herzustellen.

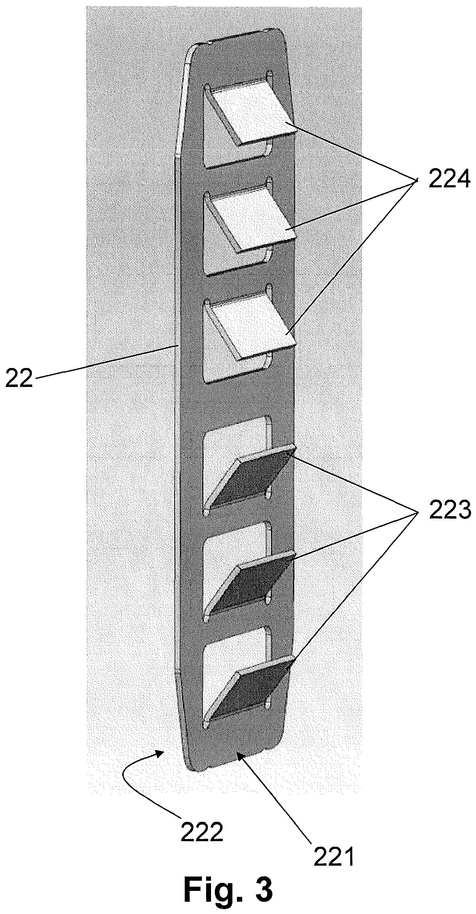

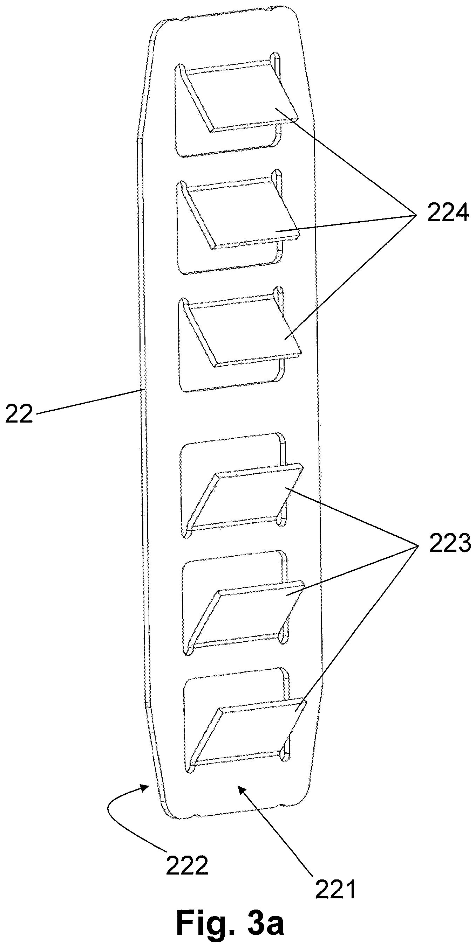

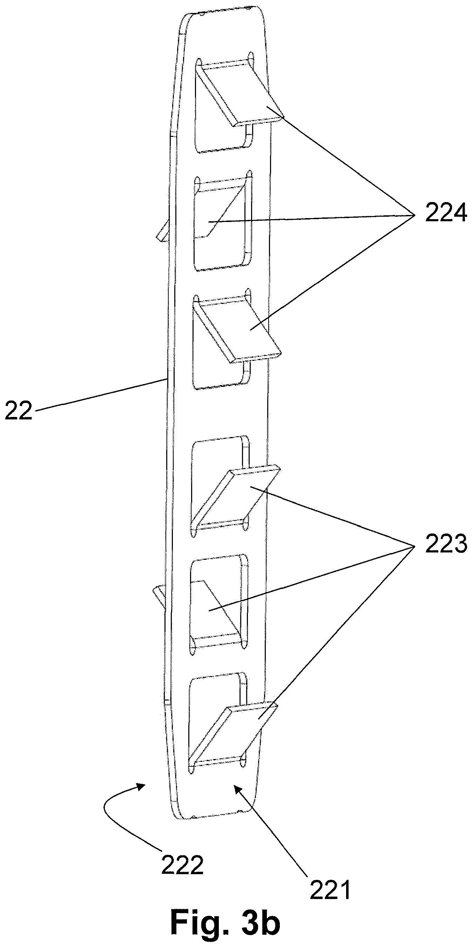

Figur 3 zeigt schematisch ein Verschlusselement 22, welches für die Halterung in den Halterungseinrichtungen 112, 122 der Gehäuseteile 11, 12 vorgesehen ist. Das Verschlusselement 22 ist in der Form eines Plättchens bzw. streifenartig ausgeführt und erstreckt sich entlang einer Einführrichtung, in der es in die Haltereinrichtungen 121, 122 einführbar ausgestaltet ist. Das Verschlusselement 22 weist zwei sich gegenüberliegende Seitenflächen 221, 222 auf, Federnde Elemente stehen von einer der Seitenflächen - nämlich von der Seitenflächen mit dem Bezugszeichen 221 - quer oder zumindest schräg zur Einführrichtung ab. Die federnden Elemente bilden zur Seitenfläche einen Winkel von mehr als 0° und von weniger als 90°, bevorzugt einen Winkel von zwischen 15° bis 60°, besonders bevorzugt einen Winkel von 35° bis 40°. Der Winkel ist angepasst an die Dimensionen der Halterungseinrichtungen 112, 122, insbesondere an einen Abstand zwischen Flächen des schacht- und/oder schlitzförmig ausgeführten Innenraums. Wie aus der Figur 3 schematisch ersichtlich ist, kann das Verschlusselement 22 in einem Stanzvorgang hergestellt sein, wobei die federnden Elemente 223, 224 durch ein Stanzwerkzeug oder ähnlichem aus dem plättchenförmigen Verschlusselement 22 teilweise ausgestanzt und herausgebogen werden. Alternativ kann der Stanzvorgang durch ein Spritzgiessverfahren ergänzt oder ersetzt werden, um das Verschlusselement zumindest abschnittsweise aus einem Kunststoff herzustellen. Insbesondere im Fall eines Spritzgiessverfahren lässt sich das Verschlusselement 22 optimieren, indem die Kante der federnden Elemente 223, 224, die für das Verhaken mit der Halterungseinrichtung 112, 122 vorgesehen ist, eine dafür optimal angepasste Form aufweist, beispielsweise messerförmig, indem der Abschnitt der federnden Elemente 223, 224, welche die Federwirkung ermöglicht, dazu optimiert ist, beispielsweise durch die Wahl einer Dicke, und indem der Abschnitt, welcher den Körper und die Basis für die federnden Elemente 223, 224 bildet, ein Profil aufweist, welches die Stabilität des Verschlusselements beim Einstecken in die Halterungseinrichtungen 112, 122 optimiert.

Wie in Figur 3 dargestellt, sind zwei Gruppen federnde Elemente 223, 224 vorgesehen, wobei die Gruppe mit dem Bezugszeichen 223 vorgesehen ist, sich in dem einen Gehäuseteil mit dem Bezugszeichen 11 zu erstrecken und die Gruppe mit dem Bezugszeichen 224 vorgesehen ist, sich in dem Gehäuseteil mit dem Bezugszeichen 12 zu erstrecken. Bevorzugt beträgt die Anzahl federnder Elemente 223, 224 drei pro Gruppe. Die Anzahl federnder Elemente 223, 224 pro Gruppe kann einen den jeweiligen Anforderungen entsprechenden Wert aufweisen. Die Gruppen können eine unterschiedliche Anzahl federnde Elemente 223, 224 aufweisen. Wie in der Figur 3 ersichtlich ist, sind die federnden Elemente 223, 224 unterschiedlich bzw. gegenläufig derart ausgerichtet, dass das Einstecken in die betreffende Halterungseinrichtung 112, 122 und das Verhaken damit ermöglicht ist.

Wie in Figur 3 schematisch dargestellt, sind Endabschnitte des Verschlusselements 22 in der Form eines gleichschenkligen, symmetrischen Trapez ausgeführt. Dadurch kann sich das Einstecken des Verschlusselements 22 in die Halterungseinrichtungen 112, 122 vereinfachen. Die Enden können zusätzlich gekrümmt ausgeführt sein, wobei die damit verbundene Steifigkeitserhöhung ein vereinfachtes Einstecken ermöglicht.

Beim Zusammenfügen der Gehäuseteile kann das Verschlusselement 22 in die Halterungseinrichtungen 112, 122 hineingesteckt werden, da die federnden Elemente 223, 224 derart zurückfedern können, dass das Einstecken in die Halterungseinrichtungen 112, 122 ermöglicht ist. Nach dem Zusammenfügen der Gehäuseteile 11, 12 verhaken sich die federnden Elemente mit den Halterungseinrichtungen 112, 122. Der Winkel in welchem die federnden Elemente 223, 224 von der Seitenfläche mit dem Bezugszeichen 221 abstehen ist so gewählt, dass ein optimales Verhaken gewährleistet ist, wobei ein Einrasten, Klemmen, etc. optimal gewährleistet ist. Die federnden Elemente 223, 224 können einseitig oder beidseitig vom Verschlusselement 22 abstehen.

Figur 3a zeigt schematisch eine Strichzeichnung eines Verschlusselements 22, mit zwei Gruppen federnder Elemente 223, 224, welche einseitig vom Verschlusselement 22 abstehen. Das Verschlusselement 22 weist die in Verbindung mit Figur 3 aufgeführten Merkmale auf.

Figur 3b zeigt schematisch eine Strichzeichnung eines Verschlusselements 22, mit zwei Gruppen federnder Elemente 223, 224, welche beidseitig vom Verschlusselement 22 abstehen. Das Verschlusselement 22 weist die in Verbindung mit Figur 3 aufgeführten Merkmale auf.

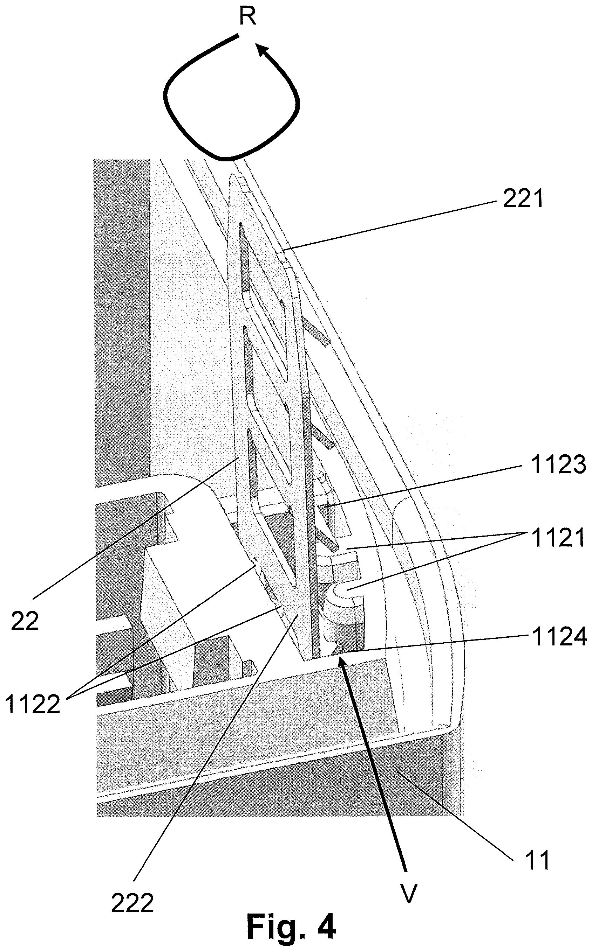

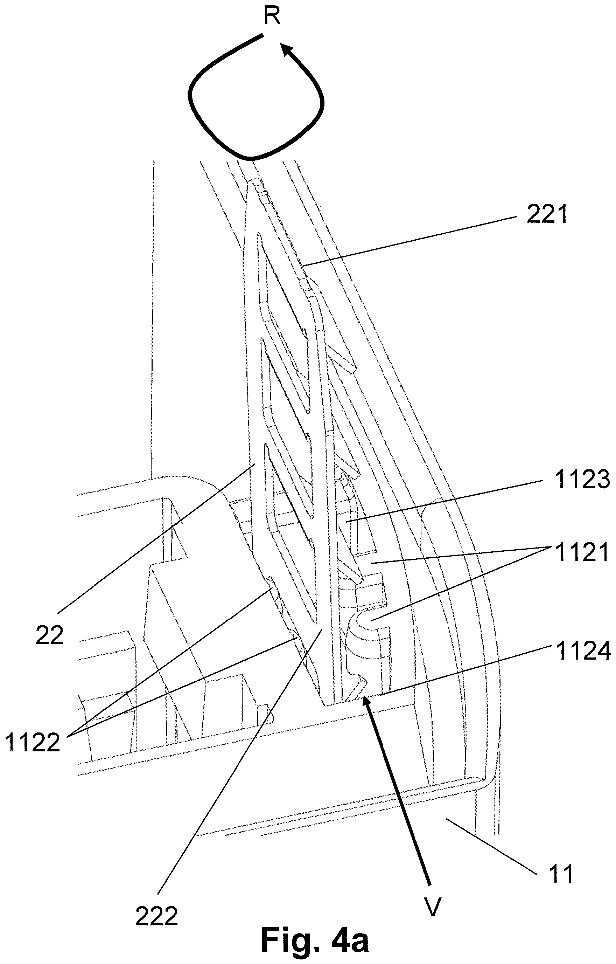

Figur 4 zeigt schematisch ein Verschlusselement 22, welches in die Halterungseinrichtung 112 eines Gehäuseteils 11 eingesteckt ist. Die zwei gegenüberliegende Seitenflächen 221, 222 des Verschlusselements 22 sind zwischen den Paaren von parallelen Rippen 1121, 1122 eingesteckt. Die Kanten des Verschlusselements 22 sind zwischen den Führungsflächen 1123, 1124 der quaderförmig ausgestalteten Halterungseinrichtung 112 eingesteckt. Das Verschlusselement 22 ist somit in der Halterungseinrichtung 112 zentriert eingesteckt. Wie in der Figur 4 mit dem Bezugszeichen V darauf hingewiesen wird und schematisch dargestellt ist, haben sich die federnden Elemente 223 mit dem einen Paar von parallelen Rippen 1121 verhakt, verzahnt, etc., wobei dies nur für eines der federnden Elemente 223 und eine Rippe des Paars von parallelen Rippen 1121 sichtbar ist. Mit anderen Worten sind die federnden Elemente 223 mindestens abschnittsweise in die Wandung bzw. Rippen 1121 der Halterungseinrichtung 112 eingedrungen und greifen somit formschlüssig in die Halterungseinrichtung 112 ein. Wie in Figur 4 dargestellt, kann es ausreichen, wenn Kanten oder Ecken der federnden Elemente 223 in die Wandung bzw. Rippen 1121 eindringen, um einen Formschluss zwischen Verschlusselement 22 und Halterungseinrichtung 112 zu bewirken.

In der Figur 4 ist mit dem Pfeil R schematisch dargestellt, dass sich das Verschlusselement 22 durch Rotation um eine Achse in zwei unterschiedlichen, um 180° verdrehten Positionen in die Halterungseinrichtung 112 einstecken lässt. Dadurch ergibt sich eine erhöhte Flexibilität bei der Montage.

Figur 4a zeigt schematisch eine Strichzeichnung eines Verschlusselements 22, welches in die Halterungseinrichtung 112 eines Gehäuseteils 11 eingesteckt ist. Das Verschlusselement 22 und die Halterungseinrichtung 112 des Gehäuseteils 11 weisen die in Verbindung mit Figur 4 aufgeführten Merkmale auf.

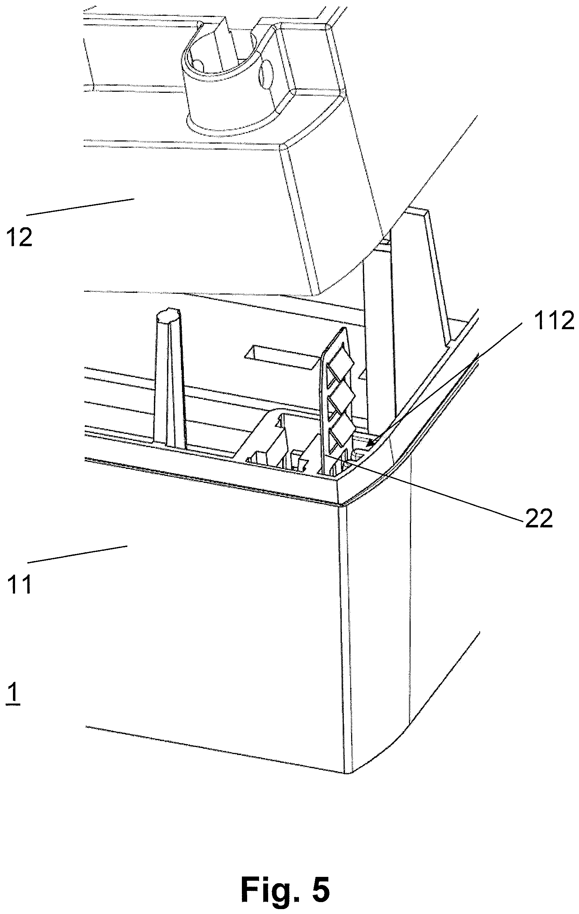

Figur 5 zeigt schematisch eine Momentaufnahme beim Zusammenfügen zu einem Gehäuse 1 eines ersten Gehäuseteils 11 und eines zweiten Gehäuseteils 12. Es ist ein Ausschnitt mit einer Ecke des Gehäuses 1 gezeigt. Im ersten Gehäuseteil 11 ist in einer am ersten Gehäuseteil 11 angebrachten Halterungseinrichtung 112 ein Verriegelungselement 22 eingesteckt und damit verhakt. Das zweite Gehäuseteil weist eine entsprechende Halterungseinrichtung 122 auf (nicht sichtbar in Figur 5), in welche das Verschlusselement 22 beim Zusammenfügen des ersten Gehäuseteils 11 und des zweiten Gehäuseteils 12 eingesteckt wird. Nach dem Zusammenfügen ist das Verschlusselement 22 mit der Halterungseinrichtung 122 des zweiten Gehäuseteils 12 verhakt. Es wird ein Formschluss bzw. eine Verriegelung zwischen den Gehäuseteilen 11, 12 hergestellt.

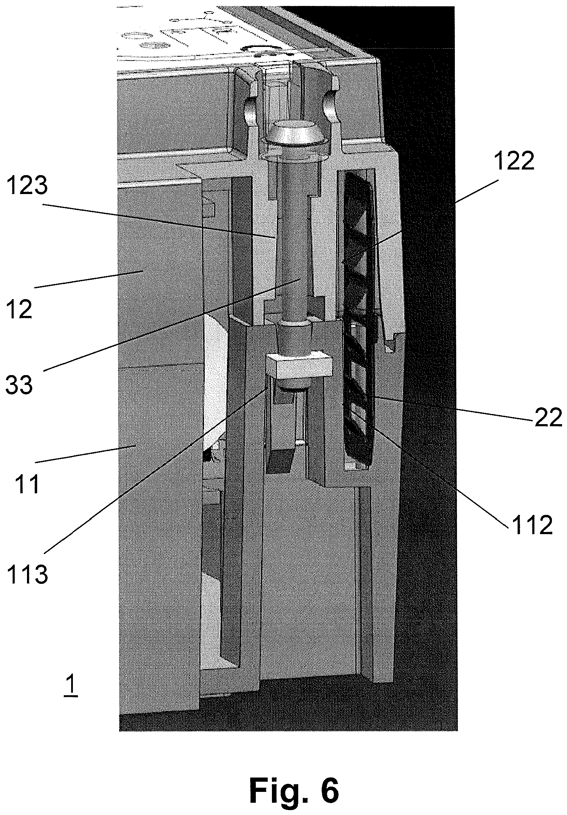

Figur 6 zeigt schematisch ein Schnittbild eines Gehäuses 1 mit einem ersten Gehäuseteil 11 und einem zweiten Gehäuseteil 12, die zusammengefügt sind. Es ist ein Ausschnitt einer Ecke des Gehäuses 1 gezeigt. Das Verschlusselement 22 erstreckt sich in der Halterungseinrichtung 112 des ersten Gehäuseteils 11 und in der Halterungseinrichtung 122 des zweiten Gehäuseteils 12. Das Verrieglungsteil 22 ist mit den Halterungseinrichtung 112, 122 verhakt, insbesondere mit den Paaren von parallel verlaufenden Rippen (in Figur 6 wenig sichtbar), die in den Halterungseinrichtung 112, 122 vorgesehen sind. Wie in Figur 6 schematisch dargestellt, ist in einer Umgebung des Verschlusselements 22 ein Verbindungselement 33 angeordnet. Das Verbindungselement 33 ist in dafür vorgesehenen Verbindungslager 113, 123 angeordnet. Wie in Figur 6 schematisch dargestellt, umfasst das Verbindungselement 33 eine Schraube, die im Gehäuseteil mit dem Bezugszeichen 12 gelagert ist und in einem Gewinde des Gehäuseteils mit dem Bezugszeichen 11 eingeschraubt ist. Es wird eine Verbindung zwischen den Gehäuseteilen 11, 12 erstellt.

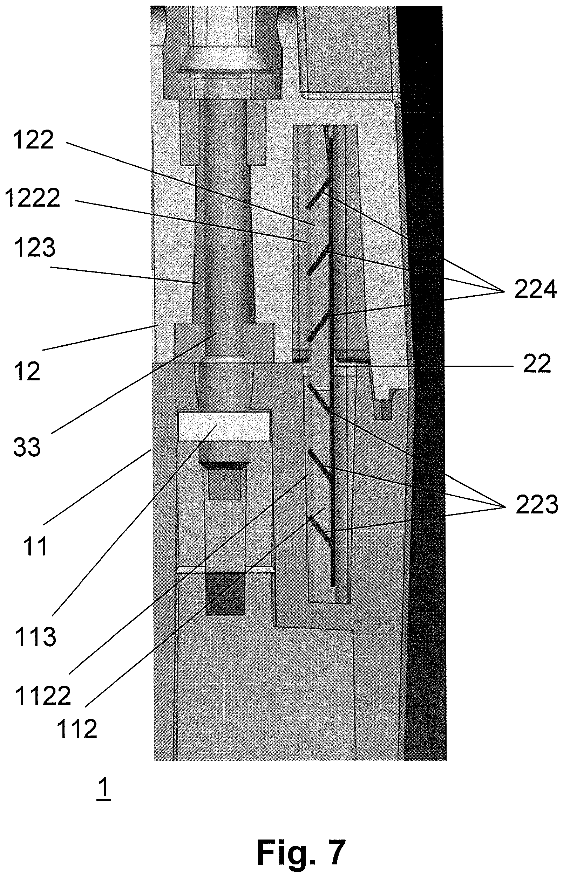

Figur 7 zeigt schematisch einen Querschnitt durch das Gehäuse 1, welches aus einem ersten Gehäuseteil 11 und einem zweiten Gehäuseteil 12 zusammengefügt ist, wobei das Verschlusselement 22 und das Verbindungselement 33 sowie die dazugehörenden Halterungseinrichtungen 112, 122 und Verbindungslager 113, 123 ersichtlich sind. Die federnden Elemente 223, 224 des Verschlusselements 22 sind mit den parallel verlaufenden Rippen 1122, 1222 der Halterungseinrichtungen 112, 122 verhakt.

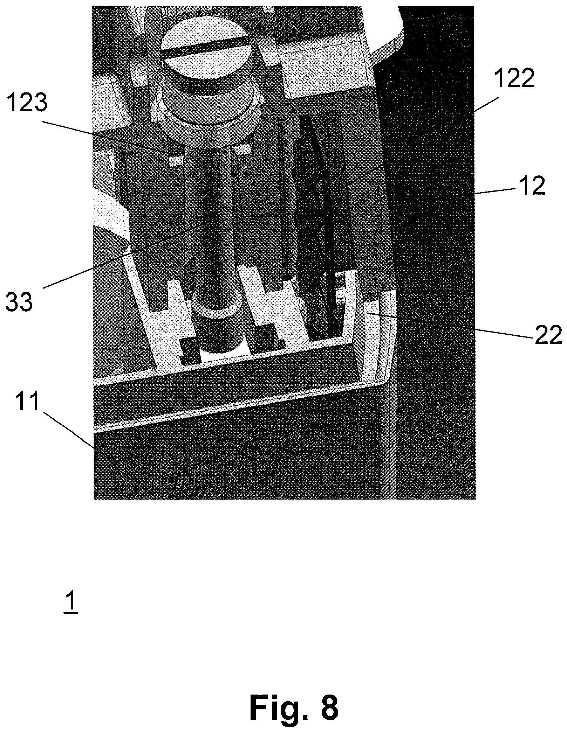

Figur 8 zeigt schematisch in einem Schnittbild eine Detailansicht des Gehäuses 1, welches aus einem ersten Gehäuseteil 11 und einem zweiten Gehäuseteil 12 zusammengefügt ist. Die Halterungseinrichtung 122 des Gehäuseteils mit dem Bezugszeichen 12 ist aufgeschnitten dargestellt, wobei das Verhaken der federnden Elemente 223, 224 des Verschlusselements 22 mit einer der parallel verlaufenden Rippen 1122, 1222 der Halterungseinrichtungen 112, 122 ersichtlich ist.

Der Abstand zwischen den Paaren von parallel verlaufenden Rippen, die Festigkeit der Rippen, die Federkraft der federnden Elemente, etc. ist so gewählt, dass ein optimales Einstecken ermöglicht und ein optimales formschlüssiges Eingreifen, Verhaken, Verzahnen, Einrasten, und/oder Klemmen, etc. gewährleistet ist. Dies kann durch die Wahl geeigneter Materialien, durch die Wahl der Winkel bei den federnden Elementen, etc. erfolgen.

Bei besonderen Ausführungen können mehr als zwei Gehäuseteile mittels den erfindungsgemässen Verschlusselementen gesichert verbunden werden. Die mehr als zwei Gehäuseteile können beispielsweise in einer seriellen Anordnung mittels den Verschlusselementen verbunden werden. Es können beispielsweise drei Gehäuseteile vorgesehen sein, wovon ein Basisteil und zwei Abdeckungsteile mittels der erfindungsgemässen Verschlusselementen gesichert verbunden werden können.

## Patentansprüche

1. Gehäuse (1) für ein Gerät, wobei das Gehäuse mindestens ein erstes Gehäuseteil (11) und ein zweites Gehäuseteil (12) umfasst, die jeweils mindestens eine Halterungseinrichtung (111, 112, 121, 122) aufweisen für die Halterung eines Verschlusselements (21, 22), das sich in einem verschlossenen Zustand des Gehäuses (1) zumindest abschnittsweise entlang der jeweiligen mindestens einen Halterungseinrichtung (111, 112, 121, 122) beider Gehäuseteile (11, 12) erstreckt und diese sichernd verbindet, **dadurch gekennzeichnet, dass** zwischen dem Verschlusselement (21, 22) und einer Wandung der jeweiligen Halterungseinrichtung (111, 112, 121, 122) beider Gehäuseteile (11, 12) ein formschlüssiger Eingriff besteht, wobei das Verschlusselement (21, 22) zumindest abschnittsweise in die Wandung eindringt.

2. Gehäuse (1) gemäss Anspruch 1, wobei die Halterungseinrichtungen (111, 112, 121, 122) und das Verschlusselement (21, 22) derart ausgebildet sind, dass beim Zusammenfügen des ersten Gehäuseteils (11) und des zweiten Gehäuseteils (12) das Verschlusselement (21, 22) in die Halterungseinrichtungen (111, 112, 121, 122) hineingesteckt werden kann.

3. Gehäuse (1) gemäss Anspruch 1 oder 2, wobei sich das Verschlusselement (21, 22) nach dem Zusammenfügen des ersten Gehäuseteils (11) und des zweiten Gehäuseteils (12) mit den Halterungseinrichtungen (111, 112, 121, 122) verhaken kann.

4. Gehäuse (1) gemäss einem der Ansprüche 1 bis 3, wobei das Verschlusselement (21, 22) plättchenförmig ausgebildet ist.

5. Gehäuse (1) gemäss einem der Ansprüche 1 bis 4, wobei am Verschlusselement (21, 22) federnde Elemente (223, 224) ausgebildet sind, die sich mit den Halterungseinrichtungen (111, 112, 121, 122) verhaken können.

6. Gehäuse (1) gemäss einem der Ansprüche 1 bis 5, wobei das Verschlusselement (21, 22) zwei gegenüberliegende Seitenflächen (221, 222) aufweist, und wobei die am Verschlusselement (21, 22) ausgebildeten federnden Elemente (223, 224) von einer der Seitenflächen (221) abstehen.

7. Gehäuse (1) gemäss einem der Ansprüche 1 bis 6, wobei die Halterungseinrichtungen (111, 112, 121, 122) quaderförmig ausgebildet sind.

8. Gehäuse (1) gemäss einem der Ansprüche 1 bis 7, wobei die Halterungseinrichtungen (111, 112, 121, 122) mindestens eine Rippe (1121, 1122) derart aufweisen, dass sich das Verschlusselement (21, 22) mit der mindestens einen Rippe (1121, 1122) verhaken kann.

9. Gehäuse (1) gemäss einem der Ansprüche 1 bis 8, wobei die Halterungseinrichtungen (111, 112, 121, 122) einander gegenüberliegende Paare von parallel verlaufenden Rippen (1121, 1122) aufweisen.

10. Gehäuse (1) gemäss einem der Ansprüche 1 bis 9, wobei das Verschlusselement (21, 22) und die Halterungseinrichtungen (111, 112, 121, 122) ausgebildet sind, dass das Verschlusselement (21, 22) in den Halterungseinrichtungen (111, 112, 121, 122) zentriert werden kann.

11. Gehäuse (1) gemäss einem der Ansprüche 1 bis 10, wobei das Verschlusselement (21, 22) und die Halterungseinrichtungen (111, 112, 121, 122) ausgebildet sind, dass sich das Verschlusselement (21, 22) in zwei unterschiedlichen Positionen in den Halterungseinrichtungen (111, 112, 121, 122) erstrecken kann.

12. Gehäuse (1) gemäss einem der Ansprüche 1 bis 11, wobei sich das Verschlusselement (21, 22) im Wesentlichen vollständig in den Halterungseinrichtungen (111, 112, 121, 122) erstreckt.

13. Gehäuse (1) gemäss einem der Ansprüche 1 bis 12, wobei das Verschlusselement (21, 22) ein Sicherheitselement aufweist.

14. Gehäuse (1) gemäss einem der Ansprüche 1 bis 13, wobei mehrere Verschlusselemente (21, 22) vorgesehen sind, die sich zumindest abschnittsweise entlang mehreren jeweiligen Halterungseinrichtungen (111, 112, 121, 122) der beiden Gehäuseteile (11, 12) erstrecken.

15. Gehäuse (1) gemäss einem der Ansprüche 1 bis 14, wobei eines oder mehrere Verbindungselemente (31, 32, 33) vorgesehen sind, um die Gehäuseteile (21, 22) miteinander zu verbinden.

## Claims

1. A housing (1) for a device, the housing comprising at least a first housing part (11) and a second housing part (12), which each have at least one holding device (111, 112, 121, 122) for holding a locking element (21, 22) which, in a closed state of the housing (1), extends at least in some parts along the respective at least one holding device (111, 112, 121, 122) of the two housing parts (11, 12) and securely connects them, **characterized in that** there is positive engagement between the locking element (21, 22) and a wall of the respective holding device (111, 112, 121, 122) of both housing parts (11, 12), the locking element (21, 22) penetrating the wall at least in sections.

2. The housing (1) according to claim 1, wherein the holding devices (111, 121, 121, 122) and the locking element (21, 22) are formed in such a way that the locking element (21, 22) can be inserted into the holding devices (111, 121, 121, 122) when assembling the first housing part (11) and the second housing part (12).

3. The housing (1) according to claim 1 or 2, wherein, after assembling the first housing part (11) and the second housing part (12), the locking element (21, 22) can hook into the holding devices (111, 121, 121, 122).

4. The housing (1) according to one of claims 1 to 3, wherein the locking element (21, 22) is formed in the shape of a platelet.

5. The housing (1) according to one of claims 1 to 4, wherein spring elements (223, 224) which are able to hook into the holding devices (111, 121, 121, 122) are formed on the locking element (21, 22).

6. The housing (1) according to one of claims 1 to 5, wherein the locking element (21, 22) has two opposing side surfaces (221, 222), and wherein the spring elements (223, 224) formed on the locking element (21, 22) protrude from one of the side surfaces (221).

7. The housing (1) according to one of claims 1 to 6, wherein the holding devices (111, 121, 121, 122) are cuboid-shaped.

8. The housing (1) according to one of claims 1 to 7, wherein the holding devices (111, 121, 121, 122) have at least one rib (1121, 1122) in such a way that the locking element can hook into the at least one rib (1121, 1122).

9. The housing (1) according to one of claims 1 to 8, wherein the holding devices (111, 121, 121, 122) have mutually opposing pairs of parallel ribs (1121, 1122).

10. The housing (1) according to one of claims 1 to 9, wherein the locking element (21, 22) and the holding devices (111, 121, 121, 122) are formed in such a way that the locking element (21, 22) can be centered in the holding devices (111, 121, 121, 122).

11. The housing (1) according to one of claims 1 to 10, wherein the locking element (21, 22) and the holding devices (111, 121, 121, 122) are formed such that the locking element (21, 22) can extend in two different positions in the holding devices (111, 121, 121, 122).

12. The housing (1) according to one of claims 1 to 11, wherein the locking element (21, 22) extends substantially completely within the holding devices (111, 121, 121, 122).

13. The housing (1) according to one of claims 1 to 12, wherein the locking element (21, 22) comprises a security element.

14. The housing (1) according to one of claims 1 to 13, wherein a plurality of locking elements (21, 22) which extend at least in some sections along a plurality of respective holding devices (111, 121, 121, 122) of the two housing parts (11, 12), are provided.

15. The housing (1) according to one of claims 1 to 14, wherein one or more connecting elements (31, 32, 33) are provided in order to connect the housing parts (21, 22) to one another.

## Revendications

1. Boîtier (1) destiné à un appareil, le boîtier comprenant au moins une première partie de boîtier (11) et une seconde partie de boîtier (12), lesquelles présentent respectivement au moins un dispositif de maintien (111, 112, 121, 122) destiné à maintenir un élément de fermeture (21, 22), lequel s'étend à l'état fermé du boîtier (1) au moins par sections le long de l'au moins un dispositif de maintien (111, 112, 121, 122) respectif des deux parties de boîtier (11, 12) et les relie solidement, **caractérisé en ce qu'**une mise en prise par complémentarité de forme existe entre l'élément de fermeture (21, 22) et une paroi du dispositif de maintien (111, 112, 121, 122) respectif des deux parties de boîtier (11, 12), l'élément de fermeture (21, 22) pénétrant dans la paroi au moins par sections.

2. Boîtier (1) selon la revendication 1, dans lequel les dispositifs de maintien (111, 112, 121, 122) et l'élément de fermeture (21, 22) sont conçus de telle sorte que lorsque la première partie de boîtier (11) et la seconde partie de boîtier (12) sont assemblées, l'élément de fermeture (21, 22) peut être inséré dans les dispositifs de maintien (111, 112, 121, 122).

3. Boîtier (1) selon la revendication 1 ou 2, dans lequel l'élément de fermeture (21, 22) peut s'accrocher sur les dispositifs de maintien (111, 112, 121, 122) après l'assemblage de la première partie de boîtier (11) et de la seconde partie de boîtier (12).

4. Boîtier (1) selon l'une des revendications 1 à 3, dans lequel l'élément de fermeture (21, 22) est conçu sous la forme d'une plaque.

5. Boîtier (1) selon l'une des revendications 1 à 4, dans lequel des éléments élastiques (223, 224) sont conçus sur l'élément de fermeture (21, 22), lesquels peuvent s'accrocher sur les dispositifs de maintien (111, 112, 121, 122).

6. Boîtier (1) selon l'une des revendications 1 à 5, dans lequel l'élément de fermeture (21, 22) présente deux surfaces latérales opposées (221, 222), et dans lequel les éléments élastiques (223, 224) formés sur l'élément de fermeture (21, 22) font saillie à partir de l'une des surfaces latérales (221).

7. Boîtier (1) selon l'une des revendications 1 à 6, dans lequel les dispositifs de maintien (111, 112, 121, 122) sont cubiques.

8. Boîtier (1) selon l'une des revendications 1 à 7, dans lequel les dispositifs de maintien (111, 112, 121, 122) présentent au moins une nervure (1121, 1122) de telle sorte que l'élément de fermeture (21, 22) peut s'accrocher sur l'au moins une nervure (1121, 1122).

9. Boîtier (1) selon l'une des revendications 1 à 8, dans lequel les dispositifs de maintien (111, 112, 121, 122) présentent des paires opposées de nervures (1121, 1122) parallèles.

10. Boîtier (1) selon l'une des revendications 1 à 9, dans lequel l'élément de fermeture (21, 22) et les dispositifs de maintien (111, 112, 121, 122) sont conçus de sorte que l'élément de fermeture (21, 22) peut être centré dans les dispositifs de maintien (111, 112, 121, 122).

11. Boîtier (1) selon l'une des revendications 1 à 10, dans lequel l'élément de fermeture (21, 22) et les dispositifs de maintien (111, 112, 121, 122) sont conçus de sorte que l'élément de fermeture (21, 22) peut s'étendre dans les dispositifs de maintien (111, 112, 121, 122) en deux positions différentes.

12. Boîtier (1) selon l'une des revendications 1 à 11, dans lequel l'élément de fermeture (21, 22) s'étend sensiblement complètement dans les dispositifs de maintien (111, 112, 121, 122).

13. Boîtier (1) selon l'une des revendications 1 à 12, dans lequel l'élément de fermeture (21, 22) présente un élément de sécurité.

14. Boîtier (1) selon l'une des revendications 1 à 13, dans lequel plusieurs éléments de fermeture (21, 22) sont prévus, lesquels s'étendent au moins par sections le long de plusieurs dispositifs de maintien (111, 112, 121, 122) respectifs des deux parties de boîtier (11, 12).

15. Boîtier (1) selon l'une des revendications 1 à 14, dans lequel un ou plusieurs éléments de liaison (31, 32, 33) sont prévus pour relier les parties de boîtier (21, 22) entre elles.
